# EUROPEAN PATENT APPLICATION

(11) **EP 4 815 707 A1**
(43) Date of publication of application: **30.09.2026**
(21) Application number: 25224423.1
(22) Date of filing: 17.12.2025
(51) Int. Cl.: H10W 20/20, H10D 30/00, H10D 62/10, H10D 84/85, H10W 20/41, H10W 20/40, H10W 20/00

(54) **STANDARD CELL ARCHITECTURE WITH FRONTSIDE AND BACKSIDE POWER VIA CONNECTIONS**

(30) Priority: 26.03.2025 US 202519091305
(71) Applicant: Intel Corporation, Santa Clara, CA 95054 (US)
(72) Inventor: LI, Xia, San Diego, 92130 (US); APRAMEYAN, Prashanth, San Jose, 95135 (US); CHEHAB, Bilal, Portland, 97202 (US)
(74) Representative: 2SPL Patentanwälte PartG mbB

(57) **Abstract**

Techniques are provided herein to form an integrated circuit with a standard cell layout that can utilize both frontside and backside connections along with power vias to provide either frontside or backside power rails to the circuit. The standard cell layout may include, for example, two total transistors with one transistor being an n-channel device with the other being a p-channel device. Power vias may be arranged at the boundaries of the standard cell layout, along with both frontside and backside connections to enable either frontside or backside compatible layouts for the power delivery. In some examples, each of the devices of the standard cell may be GAA transistors that each have a number of nanoribbons or other semiconductor bodies (e.g., one to four) extending in the same direction. Other standard cell layouts may include, for example, four total transistors arranged in a NAND or a NOR configuration.

## Description

### BACKGROUND

As integrated circuits continue to scale downward in size, a number of challenges arise. For instance, pitch scaling between adjacent devices of memory and logic cells becomes increasingly difficult as the gate lengths continue to decrease. Delivering power and ground rails to such devices also becomes difficult as spacing requirements make it difficult to include vias for connecting between frontside and backside interconnects. Accordingly, there remain a number of non-trivial challenges with respect to forming such high-density semiconductor devices.

### BRIEF DESCRIPTION OF THE DRAWINGS

Figure 1A is a plan view of a standard cell layout with devices having both frontside and backside connections connected by power vias along boundaries of the cell layout, in accordance with an embodiment of the present disclosure.
Figure 1B is a cross-section view of the standard cell layout from Figure 1A showing the frontside and backside connections between power vias, in accordance with an embodiment of the present disclosure.
Figures 2A and 2B are plan and cross-sectional views that illustrate one stage in an example process for forming a standard cell layout of an integrated circuit with frontside and backside contacts connected by power vias, in accordance with an embodiment of the present disclosure.
Figures 3A and 3B are plan and cross-sectional views that illustrate another stage in the example process for forming a standard cell layout of an integrated circuit with frontside and backside contacts connected by power vias, in accordance with an embodiment of the present disclosure.
Figures 4A and 4B are plan and cross-sectional views that illustrate another stage in the example process for forming a standard cell layout of an integrated circuit with frontside and backside contacts connected by power vias, in accordance with an embodiment of the present disclosure.
Figures 5A and 5B are plan and cross-sectional views that illustrate another stage in the example process for forming a standard cell layout of an integrated circuit with frontside and backside contacts connected by power vias, in accordance with an embodiment of the present disclosure.
Figures 6A and 6B are plan and cross-sectional views that illustrate another stage in the example process for forming a standard cell layout of an integrated circuit with frontside and backside contacts connected by power vias, in accordance with an embodiment of the present disclosure.
Figures 7A and 7B are plan and cross-sectional views that illustrate another stage in the example process for forming a standard cell layout of an integrated circuit with frontside and backside contacts connected by power vias, in accordance with an embodiment of the present disclosure.
Figures 8A and 8B are plan and cross-sectional views that illustrate another stage in the example process for forming a standard cell layout of an integrated circuit with frontside and backside contacts connected by power vias, in accordance with an embodiment of the present disclosure.
Figures 9A and 9B are plan and cross-sectional views that illustrate another stage in the example process for forming a standard cell layout of an integrated circuit with frontside and backside contacts connected by power vias, in accordance with an embodiment of the present disclosure.
Figures 10A and 10B are plan and cross-sectional views that illustrate another stage in the example process for forming a standard cell layout of an integrated circuit with frontside and backside contacts connected by power vias, in accordance with an embodiment of the present disclosure.
Figures 11A and 11B are plan and cross-sectional views that illustrate another stage in the example process for forming a standard cell layout of an integrated circuit with frontside and backside contacts connected by power vias, in accordance with an embodiment of the present disclosure.
Figures 12A and 12B are plan and cross-sectional views that illustrate another stage in the example process for forming a standard cell layout of an integrated circuit with frontside and backside contacts connected by power vias, in accordance with an embodiment of the present disclosure.
Figures 13A and 13B are plan and cross-sectional views that illustrate another stage in the example process for forming a standard cell layout of an integrated circuit with frontside and backside contacts connected by power vias, in accordance with an embodiment of the present disclosure.
Figures 14A and 14B are plan and cross-sectional views that illustrate another stage in the example process for forming a standard cell layout of an integrated circuit with frontside and backside contacts connected by power vias, in accordance with an embodiment of the present disclosure.
Figure 15 illustrates a cross-sectional view of a chip package containing one or more semiconductor dies, in accordance with some embodiments of the present disclosure.
Figure 16 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit with a standard cell layout that can utilize both frontside and backside connections along with power vias to provide either frontside or backside power rails to the circuit. According to some such examples, the standard cell layout may include two total transistors with one transistor being an n-channel device with the other being a p-channel device. Other examples may have a different standard cell configuration, but still apply the techniques described herein. The transistors may be configured, for instance, as an inverter or other functional circuit. According to some embodiments, power vias are arranged at the boundaries of the standard cell layout, along with both frontside and backside connections to enable either frontside or backside compatible layouts for the power delivery. The techniques can be used in any number of transistor technologies, but are particularly useful in gate-all-around (GAA) (e.g., nanoribbon) transistor configurations or forksheet transistor configurations. In some such examples, each of the devices of the standard cell may be GAA transistors that each have a number of nanoribbons or other semiconductor bodies (e.g., one to four) extending in the same direction. Other standard cell layouts may include, for instance, four total transistors arranged in a NAND or a NOR configuration. Still other standard cells may be configured differently. Numerous variations and embodiments will be apparent in light of this disclosure.

### General Overview

As previously noted above, there remain a number of non-trivial challenges with respect to integrated circuit fabrication. The boundaries of a standard unit cell define the layout, for instance, of at least a single combinatorial field-effect-transistor (CFET) architecture (e.g., one n-channel transistor and one p-channel transistor). The CFET architecture in the standard unit cell can be used to provide logic circuits, such as an inverter circuit, an AND-gate, an OR-gate, a NAND-gate, or a NOR-gate, and may be repeated across a larger layout of the integrated circuit. Some standard cell layouts may include two CFET architectures (e.g., four total transistors) arranged in a NAND or a NOR configuration. The size of the standard cell may be constrained by the number of signal/power tracks and contacts that are included both on the frontside and on the backside of the device layer. It can be challenging to provide a layout design that is compatible for both frontside and backside power connections given the differing design rules between frontside and backside interconnects.

Thus, and in accordance with an embodiment of the present disclosure, techniques are provided herein to form a layout for a standard unit cell that provides options for both frontside and backside connections using power vias to deliver power and/or ground to the transistor elements. According to some embodiments, the standard cell includes a first semiconductor device having a first semiconductor region extending lengthwise in a first direction between first source or drain regions and a second semiconductor device having a second semiconductor region extending lengthwise in the first direction (e.g., parallel to the first semiconductor region) between second source or drain regions. A gate structure extends in a second direction substantially orthogonal to the first direction across both the first and second semiconductor regions. Each of the first and second source or drain regions includes a topside contact that extends away from the corresponding source or drain region along the second direction. According to some embodiments, power vias extend downwards through the device layer between the topside contacts and corresponding backside layers to facilitate signal or power routing from either the frontside (topside or top surface) or backside (bottom-side or bottom surface). The power vias may extend in the first direction along boundaries of the standard unit cell. One or more conductive vias may extend between the topside contacts and topside conductive layers that also extend in the first direction along boundaries of the standard unit cell, such that the topside conductive layers may be aligned with the power vias along one or more boundaries of the standard cell and/or may be aligned with the backside layers along one or more boundaries of the standard cell.

According to an embodiment, an integrated circuit includes a first semiconductor region extending from a first source or drain region in a first direction, a second semiconductor region extending from a second source or drain region in the first direction, a gate structure extending over the first semiconductor region and the second semiconductor region in a second direction substantially orthogonal to the first direction, a dielectric layer beneath the gate structure and beneath the first source or drain region and the second source or drain region, a dielectric fill adjacent to and between the first source or drain region and the second source or drain region along the second direction, a first conductive via extending through an entire height of the dielectric fill and the dielectric layer and adjacent to the first source or drain region along the second direction, a second conductive via extending through an entire height of the dielectric fill and the dielectric layer and adjacent to the second source or drain region along the second direction, a first backside conductive layer beneath the dielectric layer and contacting a bottom surface of the first conductive via, and a second backside conductive layer beneath the dielectric layer and contacting a bottom surface of the second conductive via.

According to another embodiment, an electronic device includes a chip package having one or more dies. At least one of the one or more dies includes a first semiconductor device having a first semiconductor region extending from a first source or drain region in a first direction, and a first portion of a gate structure extending over the first semiconductor region in a second direction substantially orthogonal to the first direction, a second semiconductor device having a second semiconductor region extending from a second source or drain region in the first direction, and a second portion of the gate structure extending over the second semiconductor region in the second direction, a dielectric layer beneath the gate structure and beneath the first source or drain region and the second source or drain region, a dielectric fill adjacent to and between the first source or drain region and the second source or drain region along the second direction, a first conductive via extending through an entire height of the dielectric fill and the dielectric layer and adjacent to the first source or drain region along the second direction, a second conductive via extending through an entire height of the dielectric fill and the dielectric layer and adjacent to the second source or drain region along the second direction, a first backside conductive layer beneath the dielectric layer and contacting a bottom surface of the first conductive via, and a second backside conductive layer beneath the dielectric layer and contacting a bottom surface of the second conductive via.

According to another embodiment, an integrated circuit includes a standard unit cell having a first semiconductor device and a second semiconductor device. The first semiconductor device includes a first semiconductor region extending from a first source or drain region to a second source or drain region in a first direction, and a first portion of a gate structure extending over the first semiconductor region in a second direction substantially orthogonal to the first direction. The second semiconductor device includes a second semiconductor region extending from a third source or drain region to a fourth source or drain region in the first direction, and a second portion of the gate structure extending over the second semiconductor region in the second direction. The integrated circuit further includes a first conductive via extending along the first direction and aligned along a first boundary of the standard unit cell, and a second conductive via extending along the first direction and aligned along a second boundary of the standard unit cell. The first conductive via is adjacent to the first source or drain region along the second direction, and the second conductive via is adjacent to the second source or drain region along the second direction.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a repeating standard unit cell having one or more power vias aligned along one or more boundaries of the standard unit cell along with both frontside and backside connections to the power vias. The frontside conductive layers and/or the backside conductive layers conductively coupled to the power vias may be wider compared to adjacent signal tracks for delivering power or ground to transistor elements.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

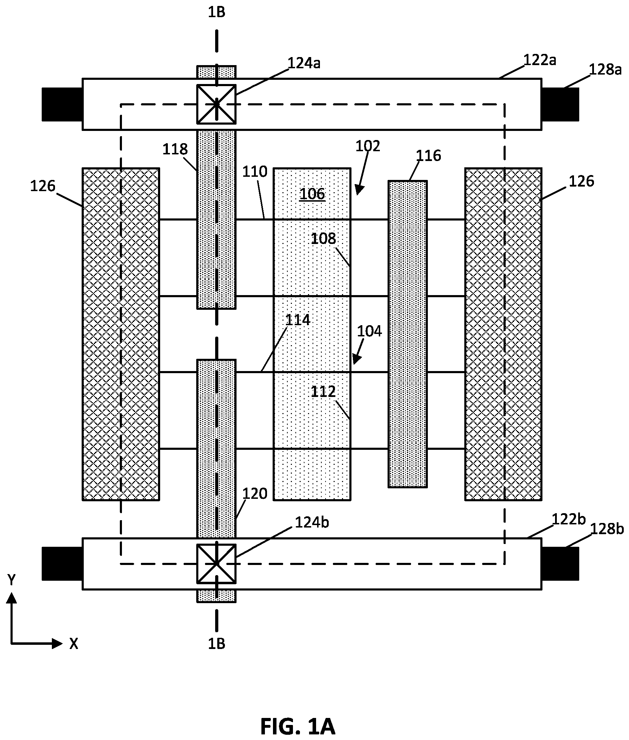

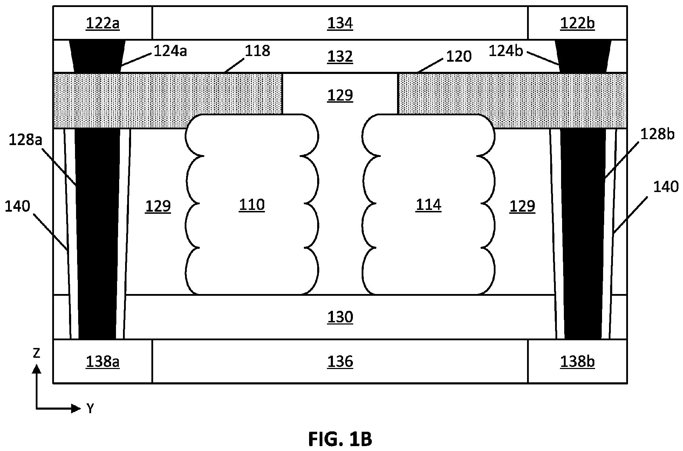

Figure 1A is a plan layout view of a standard unit cell with devices that include both frontside and backside connections to power vias, according to some embodiments. Figure 1B illustrates a cross-section view taken through plane 1B-1B as seen in Figure 1A. As shown, the standard unit cell includes a first semiconductor device 102 and a second semiconductor device 104 arranged in an inverter configuration. The boundaries of the standard unit cell are shown with dashed lines extending along the X-axis (e.g., a first direction) and along the Y-axis (e.g., a second direction). First semiconductor device 102 and second semiconductor device 104 share a gate structure 106 that extends along the second direction over the semiconductor regions of both first semiconductor device 102 and second semiconductor device 104. The semiconductor region of first semiconductor device 102 extends between a first source or drain region 108 and a second source or drain region 110 (e.g., beneath a portion of gate structure 106), and the semiconductor region of second semiconductor device 104 extends between a third source or drain region 112 and a fourth source or drain region 114 (e.g., beneath another portion of gate structure 106).

Each of semiconductor devices 102 and 104 may be, for example, non-planar metal oxide semiconductor (MOS) transistors, such as tri-gate (e.g., finFET) or gate-all-around (GAA) transistors, although other transistor topologies and types could also benefit from the techniques and structures provided herein. The semiconductor material used in each of the semiconductor devices may be formed from or on a semiconductor substrate. According to some embodiments, the substrate is removed following the completion of all topside processing and is replaced with one or more backside dielectric layers as seen in the cross-section of Figure 1B.

The one or more semiconductor regions of the devices may include fins that can be, for example, native to the substrate (formed from the substrate itself), such as silicon fins etched from a bulk silicon substrate. Alternatively, the fins can be formed of material deposited onto the substrate. In one such example case, a blanket layer of SiGe can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. Again, the alternating layers can be blanket deposited and then etched into fins or deposited into fin-shaped trenches, in some examples.

Gate structure 106 may include a gate electrode that is made up of a conductive fill and one or more metal workfunction layers, according to some embodiments. Gate structure 106 also includes a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), or doped polysilicon. In some embodiments, first semiconductor device 102 is a n-channel device having a portion of gate structure 106 with one or more workfunction layers of titanium aluminum carbide. Other metal workfunction layers of n-channel devices can include tantalum nitride (TaN). In some embodiments, second semiconductor device 104 is a p-channel device having a portion of gate structure 106 with one or more workfunction layers of tungsten. Other metal workfunction layers of p-channel devices can include tantalum nitride (TaN) and titanium nitride (TiN).

The gate dielectric of gate structure 106 may include any suitable gate dielectric material(s). In some embodiments, the gate dielectric includes a layer of native oxide material (e.g., silicon dioxide germanium dioxide, or SiGe oxide) on the semiconductor regions (e.g., nanoribbons) of semiconductor devices 102 and 104, and a layer of high-k dielectric material (e.g., hafnium oxide or aluminum oxide) on the native oxide.

According to some embodiments, a first topside contact 116 extends along the second direction across the top surfaces of both first source or drain region 108 and third source or drain region 112, a second topside contact 118 extends along the second direction across the top surface of second source or drain region 110, and a third topside contact 120 extends along the second direction across the top surface of fourth source or drain region 114. Second topside contact 118 may contact at least a portion of the top surface of second source or drain region 110 and continue to extend along the second direction to cross a boundary of the standard unit cell. Similarly, third topside contact 120 may contact at least a portion of the top surface of fourth source or drain region 114 and continue to extend along the second direction to cross an opposite boundary of the standard unit cell.

According to some embodiments, topside conductive layers 122a and 122b extend parallel to one another along the first direction and may be aligned to the top and bottom boundaries of the standard unit cell. Conductive vias 124a and 124b extend in the Z-direction (e.g., a third direction) to provide a conductive pathway between conductive layers 122a and 122b and the corresponding second topside contact 118 and third topside contact 120. Note that other conductive layers and their associated vias to connect them to gate structure 106 and first topside contact 116 are not shown for clarity. For example, any number of other topside conductive layers extending in the first direction may be included between topside conductive layers 122a and 122b (e.g., all extending parallel to one another). These other topside conductive layers may act as signal tracks to connect to various transistor elements. In some examples, three or four of these other topside conductive layers are provided between topside conductive layers 122a and 122b.

Fin isolation structures 126 are provided on either side of semiconductor devices 102 and 104. Fin isolation structures 126 may include one or more dielectric materials that extend in the second direction within their respective gate trenches to cut through any number of fins present within those gate trenches. Fin isolation structures 126 may be used to isolate the semiconductor devices of the standard unit cell from any other devices formed along the first direction on either side of the standard unit cell. Fin isolation structures 126 may include any suitable dielectric material, such as silicon nitride or any other high-k dielectric material. Fin isolation structures 126 may not be needed in situations where adjacent devices along the first direction are intended to share a given source or drain region (or where dummy transistors are employed).

As noted above, the semiconductor devices of the standard unit cell of Figure 1 may be used as an inverter circuit. Thus, first semiconductor device 102 may be a PMOS device with second semiconductor device 104 being a NMOS device, or vice versa. The input signal for the inverter is received at gate structure 106, and the output signal for the inverter is taken from first topside contact 116.

According to some embodiments, power via 128a and 128b extend in the first direction along opposite boundaries of the standard unit cell. Each power via 128a and 128b contacts a bottom surface of the corresponding first topside contact 118 and second topside contact 120, as seen more clearly in Figure 1B. In some examples, power via 128a and 128b do not extend along the entire length of the unit cell boundaries. In some examples, power via 128a and 128b are aligned in the third direction with corresponding topside conductive layers 122a and 122b. Each power via 128a and 128b may include any suitable conductive material, such as any of tungsten, ruthenium, molybdenum, or cobalt. In some examples, only one boundary of the standard unit cell includes a power via.

Turning to Figure 1B, each power via 128a and 128b extends in the third direction through both a dielectric fill 129 and a first backside dielectric layer 130. Dielectric fill 129 may extend between and over portions of the source or drain regions. In some examples, dielectric fill 129 substantially fills any remaining space within the source/drain trench that includes second source or drain region 110 and fourth source or drain region 114. First backside dielectric layer 130 may include any suitable dielectric material, such as silicon dioxide. In some examples, first backside dielectric layer 130 is formed beneath gate structure 106 and beneath the various source or drain regions. First backside dielectric layer 130 may have a thickness between 40 nm and 50 nm.

According to some embodiments, conductive vias 124a and 124b extend in the third direction through a first topside dielectric layer 132, and topside conductive layers 122a and 122b are in a second topside dielectric layer 134. Each of first topside dielectric layer 132 and second topside dielectric layer 134 may include any suitable dielectric material, such as silicon dioxide, and may be part of a topside interconnect region. A second backside dielectric layer 136 may be part of a backside interconnect region, and may also include any suitable dielectric material, such as silicon dioxide. According to some embodiments, backside conductive layers 138a and 138b contact a bottom surface of the corresponding power via 128a and 128b. Backside conductive layers 138a and 138b may extend in the first direction to deliver power and/or ground to power via 128a and 128b, respectively. Accordingly, backside conductive layers 138a/138b may be aligned with, or at least overlap with, topside conductive layers 122a/122b as they each extend along the first direction.

In some examples, a dielectric liner 140 is present on outside surfaces of power vias 128a and 128b. Dielectric liner 140 may be any suitable dielectric material having sufficient etch selectivity with dielectric fill 129 and first backside dielectric layer 130. In some examples, dielectric liner 140 includes silicon nitride or silicon oxynitride.

### Fabrication Methodology

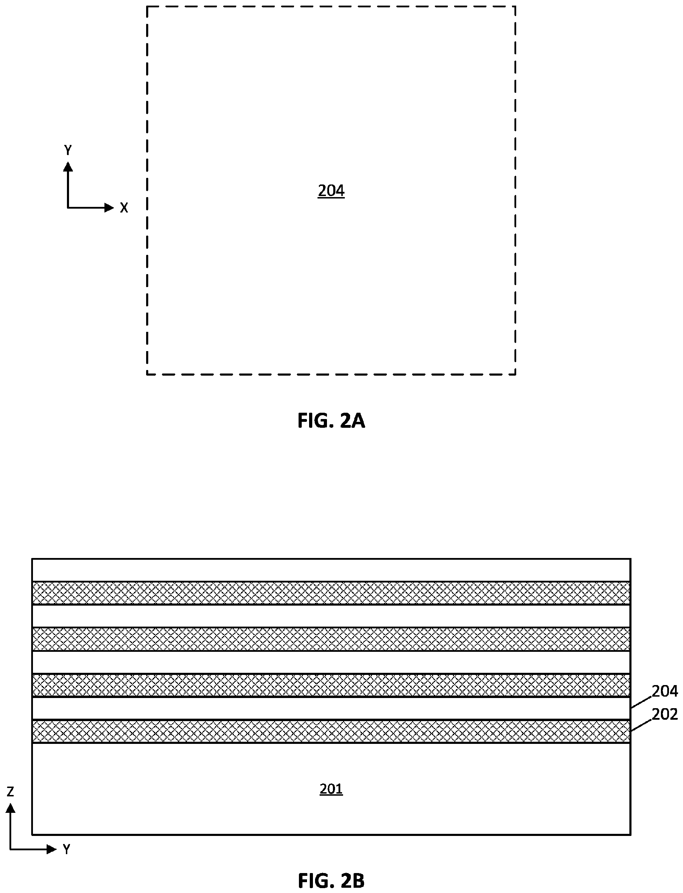

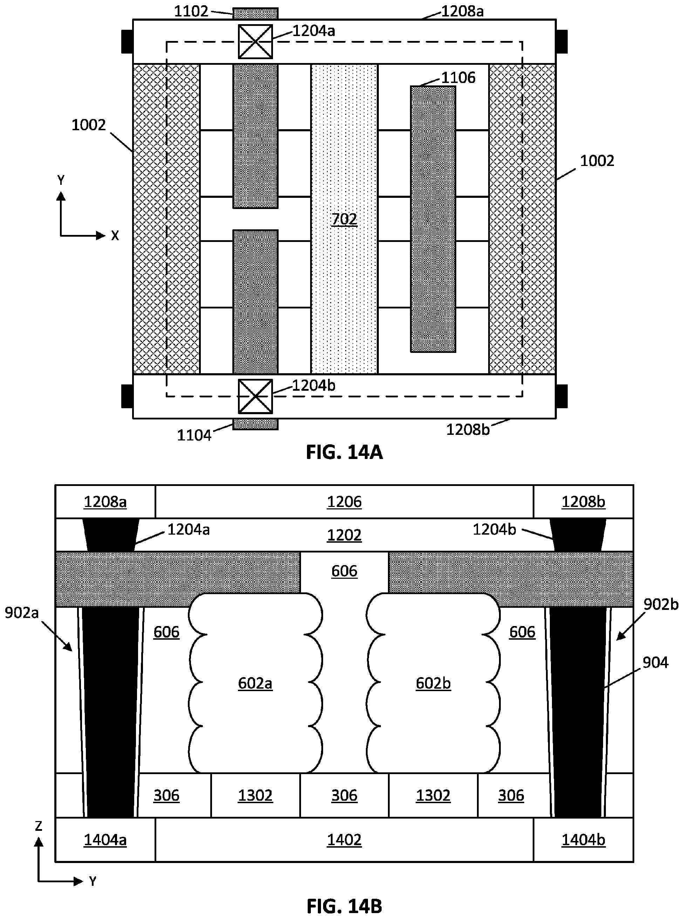

Figures 2A - 14A and 2B - 14B include plan and cross-sectional views, respectively, that collectively illustrate an example process for forming a standard cell layout of an integrated circuit with power vias having frontside and backside connections, in accordance with an embodiment of the present disclosure. Figures 2A - 14A represent a similar plan view as that of Figure 1A across the footprint of a standard unit cell, while Figures 2B - 14B represent the corresponding cross-section view similar to Figure 1B along the 1B-1B plane. Each set of figures sharing the same letter shows an example structure that results from the process flow up to that point in time, so the depicted structure evolves as the process flow continues, culminating in the structure shown in Figures 14A and 14B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Dashed lines are used in the plan view of Figures 2A - 14A to indicate the boundaries of the standard cell layout.

Figures 2A and 2B illustrate plan and cross-section views taken through a substrate 201 having a series of material layers formed over the substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202.

While dimensions can vary from one example embodiment to the next, the thickness of each semiconductor layer 204 may be between about 5 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

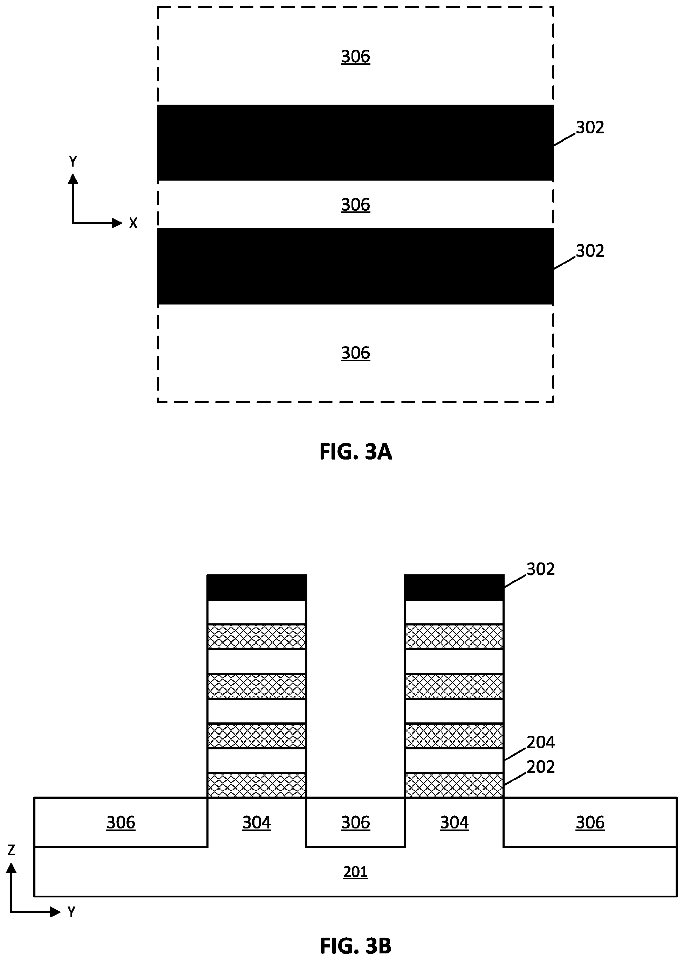

Figures 3A and 3B depict plan and cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows extending along a first direction (e.g., along the X-axis as shown in Figure 3A) to form corresponding rows of fins from the alternating layer stack of sacrificial layers 202 and semiconductor layers 204.

According to some embodiments, an anisotropic etching process using, for example, reactive ion etching (RIE) through the layer stack continues into at least a portion of substrate 201. Portions of substrate 201 beneath the fins are not etched and yield subfin regions 304. The etched portion of substrate 201 may be filled with a dielectric material to from a dielectric layer 306 that acts as shallow trench isolation (STI) between adjacent fins, as seen in Figure 3B. Dielectric layer 306 may include any dielectric material such as silicon dioxide. Subfin regions 304 represent remaining portions of substrate 201 between dielectric layer 306, according to some embodiments.

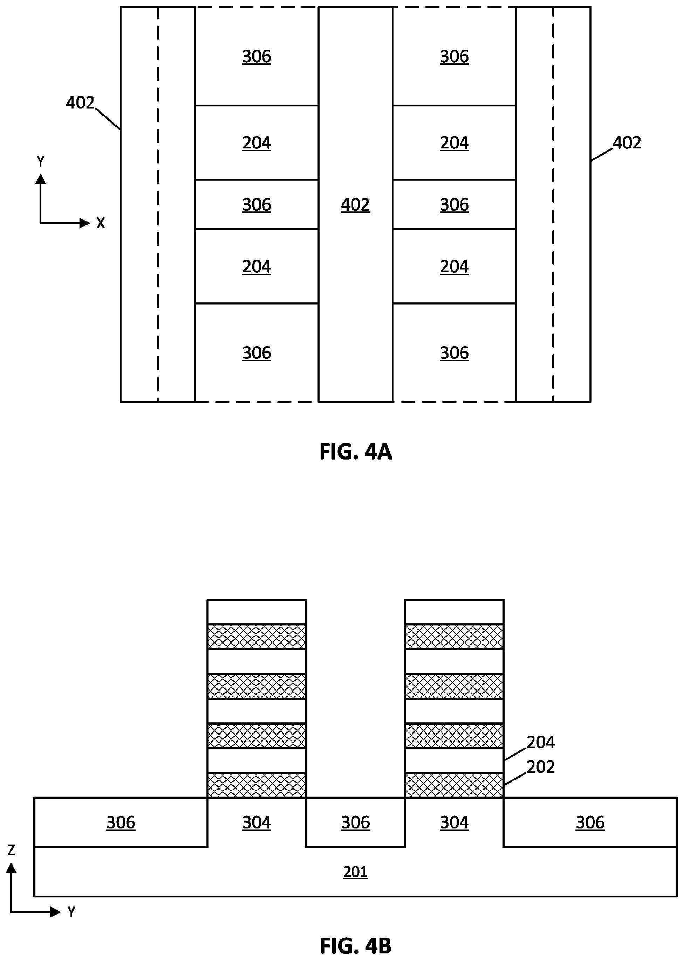

Figures 4A and 4B depict plan and cross-section views of the structure shown in Figures 3A and 3B following the formation of sacrificial gates 402, according to some embodiments. A gate masking layer may first be patterned in strips that extend orthogonally across each of the fins in a second direction (e.g., along the Y-axis as shown in Figure 4A) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gates 402 may be any material that can be selectively removed without damaging the semiconductor material of the fins. In some examples, sacrificial gates 402 includes polysilicon. It should be noted that the cross-section view in Figure 4B is taken along a source/drain trench adjacent to sacrificial gates 402, and thus does not illustrate any portion of sacrificial gates 402.

According to some embodiments, spacer structures (also referred to as gate spacers or upper gate spacers) are formed along the sidewalls of sacrificial gates 402. These spacer structures are not illustrated for clarity. The spacer structures may be deposited and then etched back such that the spacer structures remain mostly only on sidewalls of any exposed structures. According to some embodiments, the spacer structures may be any suitable dielectric material, such as silicon nitride, silicon carbon nitride, or silicon oxycarbonitride.

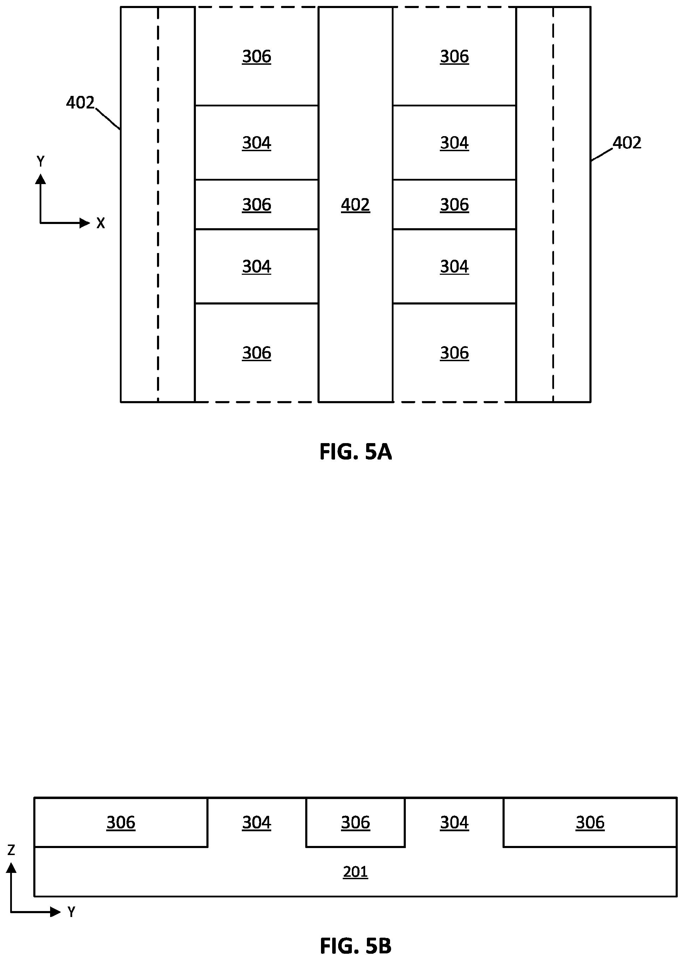

Figures 5A and 5B depict plan and cross-section views of the structure shown in Figures 4A and 4B following the removal of exposed portions of the fins not protected by sacrificial gates 402 (and the spacer structures), according to some embodiments. The exposed fin portions may be removed using any anisotropic etching process, such as RIE. The removal of the exposed fin portions creates source or drain trenches that alternate with gate trenches (currently filled with sacrificial gates 402) along the first direction, according to some embodiments. At least a portion of subfin regions 304 may be removed during the etching process.

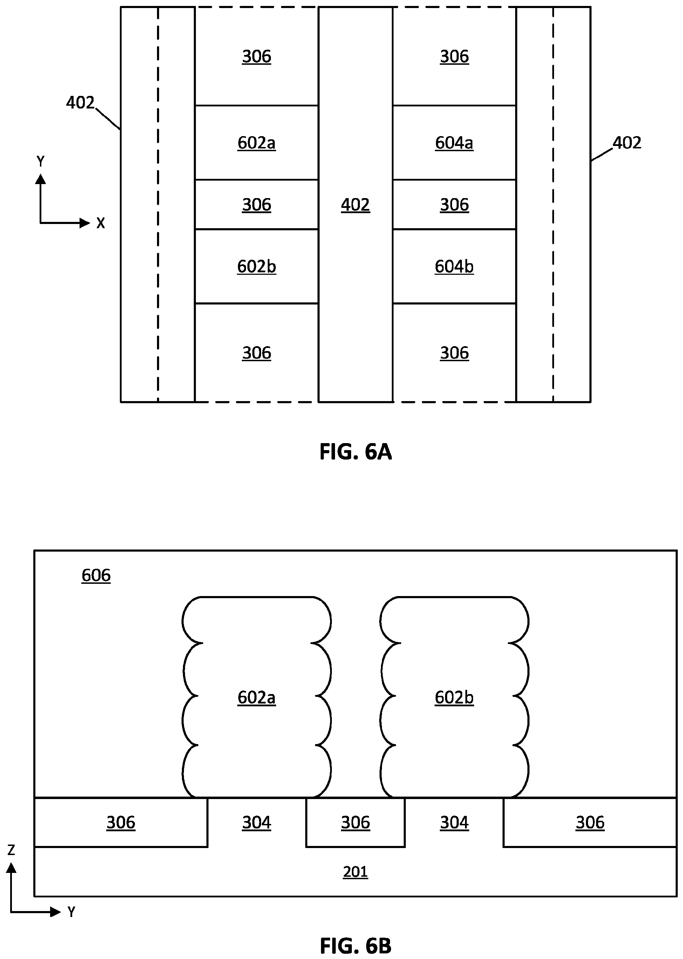

Figures 6A and 6B depict plan and cross-section views of the structure shown in Figures 5A and 5B following the formation of various source or drain regions within the source/drain trenches, according to some embodiments. Each of source or drain regions 602a/602b/604a/604b may be formed in the areas that had been previously occupied by the exposed fins within the source/drain trenches. According to some embodiments, the source or drain regions are epitaxially grown from the exposed semiconductor material at the ends of the semiconductor layers beneath the sacrificial gates 402. In some example embodiments, source or drain regions 602a and 604a are p-type source or drain regions (e.g., epitaxial silicon germanium) while source or drain regions 602b and 604b are n-type source or drain regions (e.g., epitaxial silicon), or vice versa. Accordingly, source or drain regions of one dopant type may be formed first before the formation of source or drain regions of the other dopant type.

According to some embodiments, a dielectric fill 606 is provided between adjacent source or drain regions along the source/drain trench. In some examples, dielectric fill 606 occupies a remaining volume within the source/drain trench around and over each of source or drain regions 602a and 602b, as seen in Figure 6B. Dielectric fill 606 may be any dielectric material, such as silicon dioxide. In some examples, dielectric fill 606 extends up to and planar with a top surface of sacrificial gate 402 (e.g., following a polishing procedure). A planarization process such as chemical mechanical polish (CMP) can be used to remove any excess dielectric fill 606 and planarize the structure, as shown. Dielectric fill 606 is not illustrated in the plan view of Figure 6A for clarity.

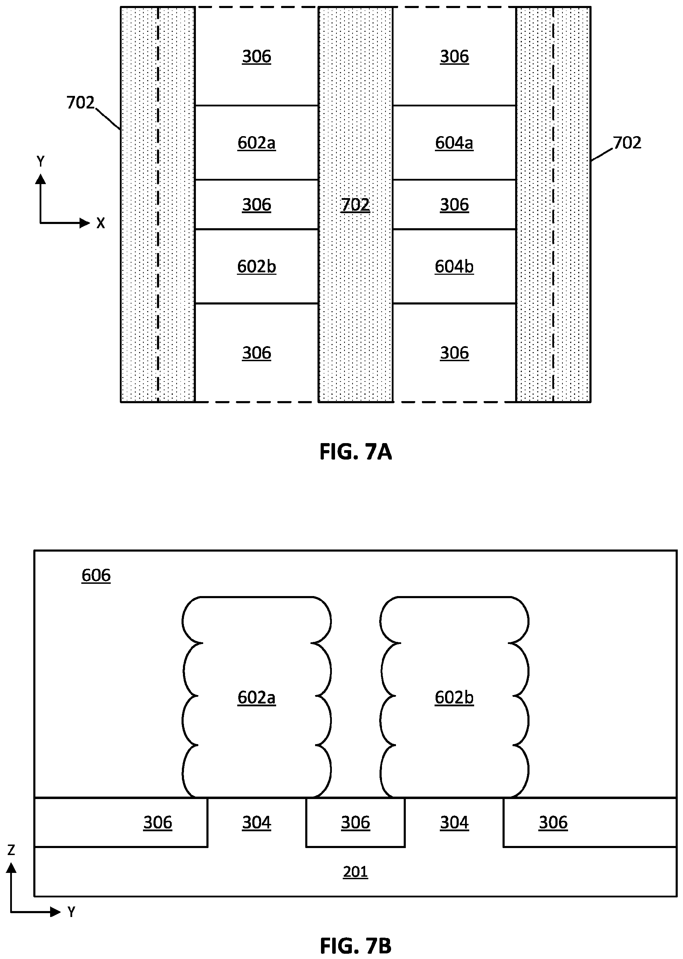

Figures 7A and 7B depict plan and cross-section views of the structure shown in Figures 6A and 6B, respectively, following the removal of sacrificial gates 402 and sacrificial layers 202 and subsequent formation of gate structures 702, according to some embodiments. In examples where gate masking layers are still present, they would be removed at this time. Once sacrificial gates 402 are removed, the fins extending between the corresponding source or drain regions are exposed.

In the example where the fins include alternating semiconductor layers, sacrificial layers 202 are selectively removed to leave behind nanoribbons that extend between corresponding source or drain regions. Each vertical (e.g., along the z-direction) set of nanoribbons represents the semiconductor region (or channel region) of a different semiconductor device. Note that the use of the term nanoribbon is not intended to exclude any particular geometries usable for a gate-all-around channel region (such as nanowires). In other embodiments, the nanoribbons of a given channel region may be a single fin structure, so as to provide a double-gate or tri-gate configuration. In still other embodiments, the nanoribbons of a given channel region may be nanosheets extending laterally from a dielectric wall, so as to provide a forksheet configuration. Sacrificial gates 402 and sacrificial layers 202 may be removed using the same isotropic etching process or different isotropic etching processes. According to some embodiments, the nanoribbons extend along the first direction beneath gate structure 702 between source or drain regions 602a and 604a, and also between source or drain regions 602b and 604b.

According to some embodiments, gate structures 702 are formed within the gate trenches over the nanoribbons or fins extending between corresponding source or drain regions. Gate structures 702 each include a gate dielectric and a gate electrode. The gate dielectric may be first formed around the nanoribbons or fin prior to the formation of the gate electrode, which may include one or more conductive layers. The gate dielectric may include any gate dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on the nanoribbons or fin, and a second layer on the first layer. The first layer can be, for instance, an oxide of the semiconductor material of the nanoribbons or fin (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

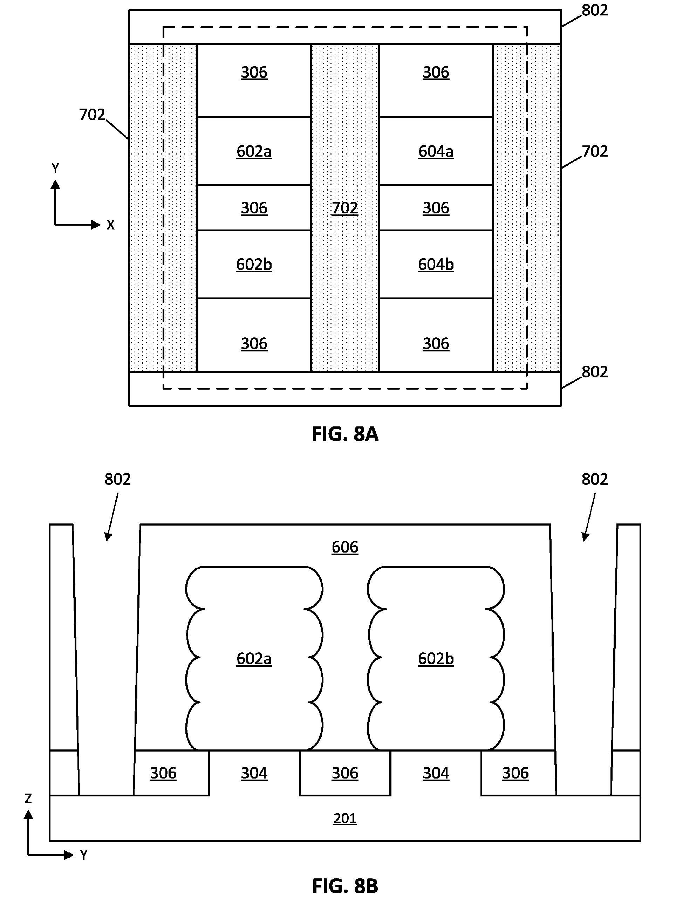

Figures 8A and 8B depict plan and cross-section views of the structure shown in Figures 7A and 7B, respectively, following the formation of trench recesses 802, according to some embodiments. An anisotropic etching process (e.g., RIE) may be used to form trench recesses 802 by etching through at least an entire thickness of dielectric fill 606 and through at least a portion of dielectric layer 306. In some examples, trench recesses 802 extend through an entire thickness of dielectric layer 306 and may also extend into at least a portion of substrate 201. As seen in Figure 8A, trench recesses 802 may extend in the first direction along the boundaries of the standard unit cell. In some examples, only one of the standard unit cell boundaries extending in the first direction has a trench recess 802. According to some embodiments, trench recesses 802 also cut across gate structures 702, and thus may extend through at least the entire thickness of the gate structure to isolate different portions of gate structures 702 along the second direction. Due to the relatively high aspect-ratio of trench recesses 802, the sidewalls of trench recesses 802 may taper inwards.

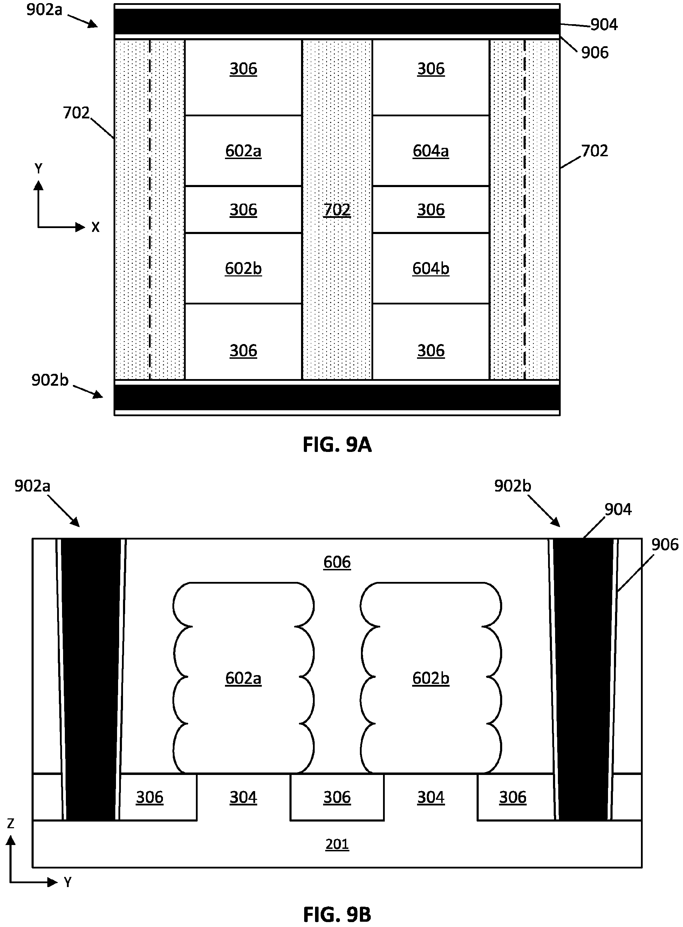

Figures 9A and 9B depict plan and cross-section views of the structure shown in Figures 8A and 8B, respectively, following the formation of power vias 902a and 902b within trench recesses 802, according to some embodiments. Each power via 902a and 902b may include a conductive core 904 and a dielectric liner 906. Conductive core 904 may include any suitable conductive material, such as tungsten, ruthenium, molybdenum, or cobalt. Dielectric liner 906 may be formed first within trench recesses 802 to conformally cover all exposed surfaces within trench recesses 802. In some examples, dielectric liner 906 includes silicon nitride or generally any dielectric material having sufficient etch selectivity to the dielectric material of dielectric fill 606. In some examples, dielectric liner 906 includes a high-k dielectric material, such as any material having a dielectric constant greater than 5.0. Dielectric liner 906 may be deposited using any suitable conformal deposition technique such as CVD, PECVD, or ALD, and may have a thickness between about 2 nm and about 10 nm. According to some embodiments, a portion of dielectric liner 906 on the bottom of trench recesses 802 is punched through using an anisotropic etch prior to the formation of conductive core 904. Accordingly, a bottom surface of conductive core 904 may contact a portion of substrate 201 or a portion of dielectric layer 306 if trench recesses 802 do not extend through the entire thickness of dielectric layer 306. As noted above, some examples may only include one power via 902a or 902b along one boundary of the standard unit cell without the other power via.

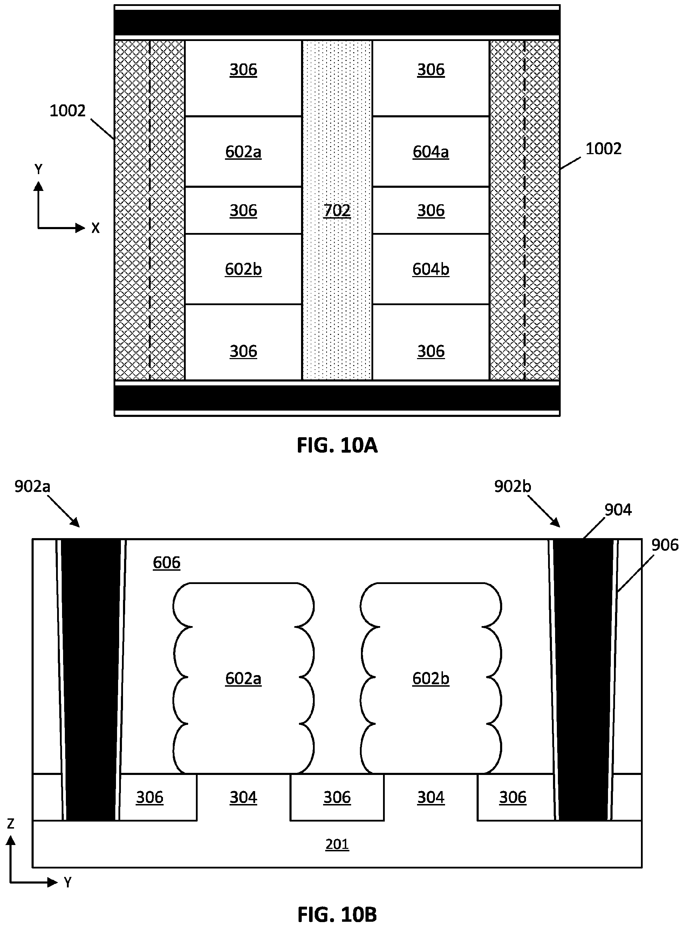

Figures 10A and 10B depict plan and cross-section views of the structure shown in Figures 9A and 9B, respectively, following the removal of the gate structures along the edges of the standard unit cell, and formation of fin isolation structures 1002 in place of the removed gate structures, according to some embodiments. In some examples, an RIE process is used to remove the gate structures on either side of the illustrated gate structure 702 and fill those gate trenches with a dielectric material to form fin isolation structures 1002. In some embodiments, the etch is performed through the gate structures between power vias 902a and 902b. Fin isolation structures 1002 may include one or more dielectric materials that extend in the second direction within their respective gate trenches between power vias 902a and 902b. In some examples, fin isolation structures 1002 also cut across one or both of power vias 902a and 902b. In the illustrated example, fin isolation structures 1002 isolate the semiconductor devices of the standard unit cell from any other devices formed along the first direction on either side of the standard unit cell. Fin isolation structures 1002 may include any suitable dielectric material, such as silicon nitride or any other high-k dielectric material. Fin isolation structures 1002 may not be needed in situations where adjacent devices along the first direction are intended to share a given source or drain region (or where dummy transistors are employed).

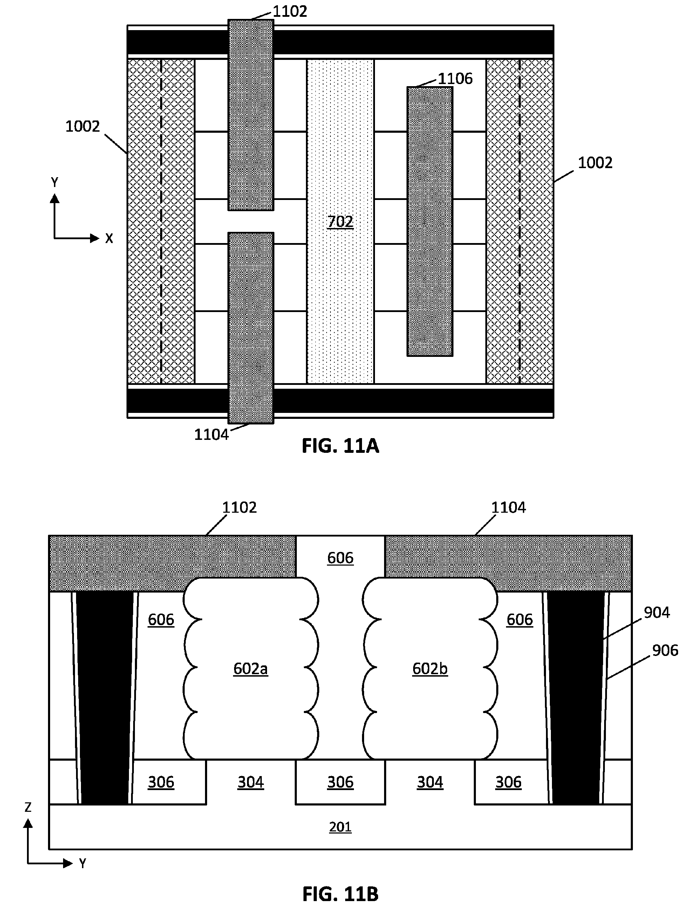

Figures 11A and 11B depict plan and cross-section views of the structure shown in Figures 10A and 10B following the formation of various topside contacts on the top surfaces of the source or drain regions, according to some embodiments. Topside contacts 1102, 1104, and 1106 may include any suitable conductive material, such as tungsten, molybdenum, cobalt, titanium, tantalum, ruthenium, or any alloys thereof, for making electrical contact with the underlying source or drain regions. As seen in the cross section of Figure 11B, portions of dielectric fill 606 are recessed to expose at least the top surfaces of source or drain regions 602a and 602b, and topside contacts 1102 and 1104 are formed within the respective recesses using any suitable metal deposition process. According to some embodiments, topside contact 1106 may extend along the second direction across the top surfaces of multiple source or drain regions, such as the top surfaces of each of source or drain regions 604a and 604b. The top surfaces of topside contacts 1102, 1104, and 1106 may be polished to be substantially coplanar with a top surface of dielectric fill 606. It should be understood that topside contacts 1102, 1104, and 1106 may be formed either before or after the formation of gate structures 702 and fin isolation structures 1002.

According to some embodiments, the etching process used to recess portions of dielectric fill 606 may also recess the top portions of power vias 902a and 902b. In this way, topside contacts 1102 and 1104 contact at least a portion of a top surface of conductive core 904 from each corresponding power via 902a and 902b. In some embodiments, the etching process used to recess portions of dielectric fill 606 etches little to none of conductive core 904, but removes exposed portions of dielectric liner 906. In such examples, topside contacts 1102 and 1104 contact top sidewalls portions of conductive core 904.

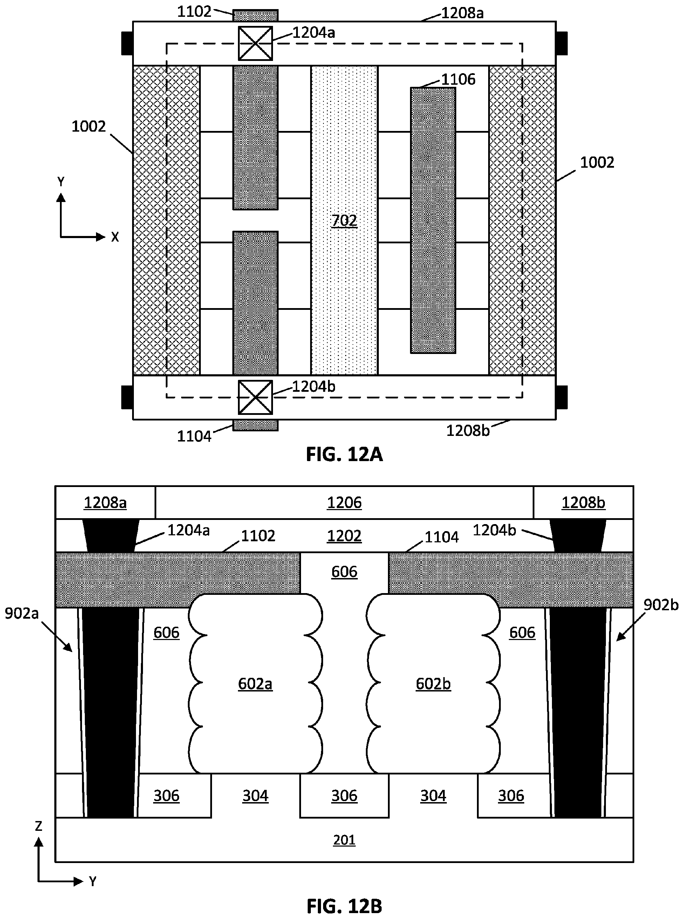

Figures 12A and 12B depict plan and cross-section views of the structure shown in Figures 11A and 11B, respectively, following the formation of a topside interconnect region having any number of interconnect layers, according to some embodiments. Each interconnect layer includes a dielectric layer along with one or more conductive vias or conductive layers. In the illustrated example, a first interconnect layer includes a first topside dielectric layer 1202, a first conductive via 1204a extending through first topside dielectric layer 1202 and contacting the underlying topside contact 1102, and a second conductive via 1204b extending through first topside dielectric layer 1202 and contacting the underlying topside contact 1104. Any number of other similar vias may be provided through first topside dielectric layer 1202 to contact topside contact 1106. In the illustrated example, a second interconnect layer includes a second dielectric layer 1206, a first topside conductive layer 1208a, and a second topside conductive layer 1208b. According to some embodiments, first conductive via 1204a extends in the third direction between first topside conductive layer 1208a and topside contact 1102, and second conductive via 1204b extends in the third direction between second topside conductive layer 1208b and topside contact 1104. According to some embodiments, first topside conductive layer 1208a and second topside conductive layer 1208b each extends in the first direction along the boundaries of the standard unit cell as seen more clearly in Figure 12A. Any number of other topside interconnect layers may be formed to route power and/or signal to various transistor elements. Note that other topside conductive layers used to route signals to gate structure 702 and/or to topside contact 1106 are not shown in Figure 10A for clarity. In some embodiments, first topside conductive layer 1208a and second topside conductive layer 1208b are aligned over power vias 902a and 902b with each extending together in the first direction along boundaries of the standard unit cell.

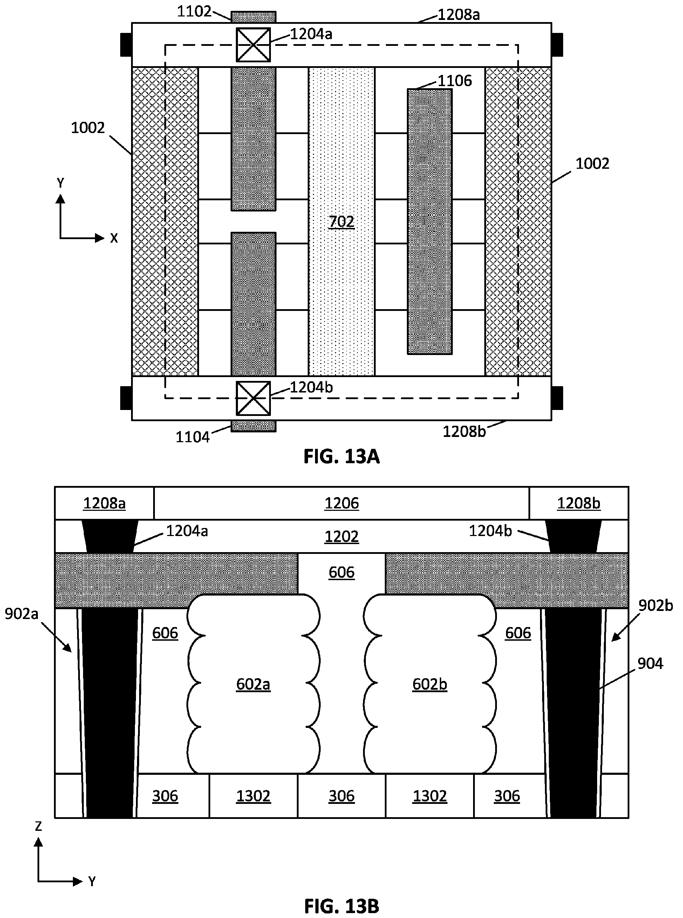

Figures 13A and 13B depict plan and cross-section views of the structure shown in Figures 12A and 12B, respectively, following the removal of substrate 201 from the backside, which exposes the bottom surface of dielectric layer 306, subfins 304, and conductive core 904 from power vias 902a and 902b, according to some embodiments. Substrate 201 may be removed using any combination of polishing, grinding, or isotropic etching processes. The backside exposed subfin regions 304 may then be etched away using any suitable isotropic etching process to yield backside cavities. According to some embodiments, one or more additional dielectric layers may be deposited within the backside cavities to form a dielectric fill 1302. Dielectric fill 1302 along with dielectric layer 306 may collectively form a base dielectric structure beneath the devices. According to some embodiments, a bottom surface of the base dielectric structure (bottom surfaces of both dielectric layer 306 and dielectric fill 1302) may be polished to be a substantially planar surface. In some embodiments, polishing of the bottom surface of the structure continues at least until the bottom surface of conductive core 904 is exposed.

Figures 14A and 14B depict plan and cross-section views of the structure shown in Figures 13A and 13B, respectively, the formation of a backside interconnect region having any number of interconnect layers, according to some embodiments. Similarly to the frontside interconnect region, each interconnect layer can include a dielectric layer along with one or more conductive vias or conductive layers. In the illustrated example, a backside interconnect layer includes a backside dielectric layer 1402, a first backside conductive layer 1404a extending through backside dielectric layer 1402 and contacting a bottom surface of power via 902a, and a second backside conductive layer 1404b extending through backside dielectric layer 1402 and contacting a bottom surface of power via 902b. Each of first backside conductive layer 1404a and second backside conductive layer 1404b can include any suitable conductive material, such as any of tungsten, ruthenium, molybdenum, or cobalt. First backside conductive layer 1404a and second backside conductive layer 1404b may extend parallel to one another along the first direction to route power and/or signal to the corresponding power vias 902a and 902b. According to some embodiments, first backside conductive layer 1404a and second backside conductive layer 1404b are comparatively wider along the second direction compared to first topside conductive layer 1208a and second topside conductive layer 1208b. In some examples, the backside conductive layers 1404a/1404b are at least 1.5x, 2x, 2.5x wider than topside conductive layers 1208a/1208b. The backside layers may be made wider due to the relaxed spacing requirements for interconnect layers on the backside of the structure, and the wider geometry makes them more suitable for use as power or ground rails for the circuit. According to some embodiments, first topside conductive layer 1208a and second topside conductive layer 1208b are aligned over the corresponding first backside conductive layer 1404a and second backside conductive layer 1404b with each extending together in the first direction along boundaries of the standard unit cell.

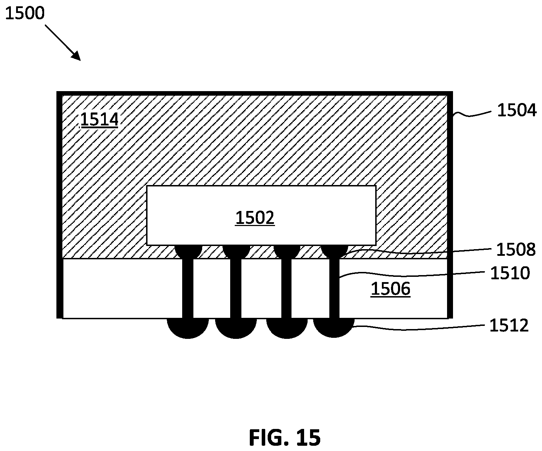

Figure 15 illustrates an example embodiment of a chip package 1500, in accordance with an embodiment of the present disclosure. As can be seen, chip package 1500 includes one or more dies 1502. One or more dies 1502 may include at least one integrated circuit having semiconductor devices, such as any of the semiconductor devices disclosed herein. One or more dies 1502 may include any other circuitry used to interface with other devices formed on the dies, or other devices connected to chip package 1500, in some example configurations.

As can be further seen, chip package 1500 includes a housing 1504 that is bonded to a package substrate 1506. The housing 1504 may be any standard or proprietary housing, and may provide, for example, electromagnetic shielding and environmental protection for the components of chip package 1500. The one or more dies 1502 may be conductively coupled to a package substrate 1506 using connections 1508, which may be implemented with any number of standard or proprietary connection mechanisms, such as solder bumps, ball grid array (BGA), pins, or wire bonds, to name a few examples. Package substrate 1506 may be any standard or proprietary package substrate, but in some cases includes a dielectric material having conductive pathways (e.g., including conductive vias and lines) extending through the dielectric material between the faces of package substrate 1506, or between different locations on each face. In some embodiments, package substrate 1506 may have a thickness less than 1 millimeter (e.g., between 0.1 millimeters and 0.5 millimeters), although any number of package geometries can be used. Additional conductive contacts 1512 may be disposed at an opposite face of package substrate 1506 for conductively contacting, for instance, a printed circuit board (PCB). One or more vias 1510 extend through a thickness of package substrate 1506 to provide conductive pathways between one or more of connections 1508 to one or more of contacts 1512. Vias 1510 are illustrated as single straight columns through package substrate 1506 for ease of illustration, although other configurations can be used (e.g., damascene, dual damascene, through-silicon via, or an interconnect structure that meanders through the thickness of substrate 1506 to contact one or more intermediate locations therein). In still other embodiments, vias 1510 are fabricated by multiple smaller stacked vias, or are staggered at different locations across package substrate 1506. In the illustrated embodiment, contacts 1512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1512, to inhibit shorting.

In some embodiments, a mold material 1514 may be disposed around the one or more dies 1502 included within housing 1504 (e.g., between dies 1502 and package substrate 1506 as an underfill material, as well as between dies 1502 and housing 1504 as an overfill material). Although the dimensions and qualities of the mold material 1514 can vary from one embodiment to the next, in some embodiments, a thickness of mold material 1514 is less than 1 millimeter. Example materials that may be used for mold material 1514 include epoxy mold materials, as suitable. In some cases, the mold material 1514 is thermally conductive, in addition to being electrically insulating.

### Example System

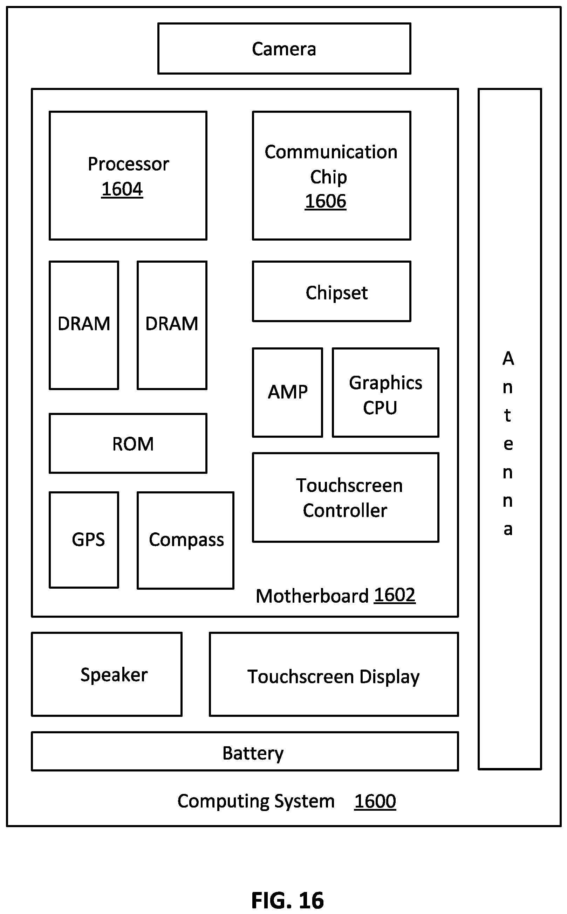

FIG. 16 is an example computing system implemented with one or more of the integrated circuit structures as disclosed herein, in accordance with some embodiments of the present disclosure. As can be seen, the computing system 1600 houses a motherboard 1602. The motherboard 1602 may include a number of components, including, but not limited to, a processor 1604 and at least one communication chip 1606, each of which can be physically and electrically coupled to the motherboard 1602, or otherwise integrated therein. As will be appreciated, the motherboard 1602 may be, for example, any printed circuit board (PCB), whether a main board, a daughterboard mounted on a main board, or the only board of system 1600, etc.

Depending on its applications, computing system 1600 may include one or more other components that may or may not be physically and electrically coupled to the motherboard 1602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1600 may include one or more integrated circuit structures or devices configured in accordance with an example embodiment (e.g., a module including one or more semiconductor devices that include a standard cell layout having both backside and frontside connections to power vias, as variously provided herein). In some embodiments, multiple functions can be integrated into one or more chips (e.g., for instance, note that the communication chip 1606 can be part of or otherwise integrated into the processor 1604).

The communication chip 1606 enables wireless communications for the transfer of data to and from the computing system 1600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1600 may include a plurality of communication chips 1606. For instance, a first communication chip 1606 may be dedicated to shorter range wireless communications such as Wi-Fi and Bluetooth and a second communication chip 1606 may be dedicated to longer range wireless communications such as GPS, EDGE, GPRS, CDMA, WiMAX, LTE, Ev-DO, and others.

The processor 1604 of the computing system 1600 includes an integrated circuit die packaged within the processor 1604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1606 also may include an integrated circuit die packaged within the communication chip 1606. In accordance with some such example embodiments, the integrated circuit die of the communication chip includes one or more semiconductor devices as variously described herein. As will be appreciated in light of this disclosure, note that multi-standard wireless capability may be integrated directly into the processor 1604 (e.g., where functionality of any chips 1606 is integrated into processor 1604, rather than having separate communication chips). Further note that processor 1604 may be a chip set having such wireless capability. In short, any number of processor 1604 and/or communication chips 1606 can be used. Likewise, any one chip or chip set can have multiple functions integrated therein.

In various implementations, the computing system 1600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor region extending from a first source or drain region in a first direction, a second semiconductor region extending from a second source or drain region in the first direction, a gate structure extending over the first semiconductor region and the second semiconductor region in a second direction substantially orthogonal to the first direction, a dielectric layer beneath the gate structure and beneath the first source or drain region and the second source or drain region, a dielectric fill adjacent to and between the first source or drain region and the second source or drain region along the second direction, a first conductive via extending through an entire height of the dielectric fill and the dielectric layer and adjacent to the first source or drain region along the second direction, a second conductive via extending through an entire height of the dielectric fill and the dielectric layer and adjacent to the second source or drain region along the second direction, a first backside conductive layer beneath the dielectric layer and contacting a bottom surface of the first conductive via, and a second backside conductive layer beneath the dielectric layer and contacting a bottom surface of the second conductive via.

Example 2 includes the integrated circuit of Example 1, wherein the dielectric layer has a thickness between 40 nm and 50 nm.

Example 3 includes the integrated circuit of Example 1 or 2, wherein the first source or drain region comprises silicon and phosphorous and the second source or drain region comprises silicon, germanium, and boron.

Example 4 includes the integrated circuit of any one of Examples 1-3, wherein the first semiconductor region comprises one or more first semiconductor nanoribbons and the second semiconductor region comprises one or more second semiconductor nanoribbons.

Example 5 includes the integrated circuit of Example 4, wherein the one or more first semiconductor nanoribbons and the one or more second semiconductor nanoribbons comprises germanium, silicon, or any combination thereof.

Example 6 includes the integrated circuit of any one of Examples 1-5, wherein the first conductive via extends along the first direction and is aligned along a first boundary of a standard unit cell that includes the first semiconductor region and the second semiconductor region, and the second conductive via extends along the first direction and is aligned along a second boundary of the standard unit cell, the second boundary being parallel to the first boundary.

Example 7 includes the integrated circuit of any one of Examples 1-6, further comprising: a first topside contact on a top surface of the first source or drain region; and a second topside contact on a top surface of the second source or drain region.

Example 8 includes the integrated circuit of Example 7, wherein the first topside contact extends along the second direction and also contacts the first conductive via, and the second topside contact extends along the second direction and also contacts the second conductive via.

Example 9 includes the integrated circuit of Example 8, further comprising a third conductive via extending between a top surface of the first topside contact and a first topside conductive layer, and a fourth conductive via extending between a top surface of the second topside contact and a second topside conductive layer.

Example 10 includes the integrated circuit of Example 9, wherein the first topside conductive layer is vertically aligned with the first backside conductive layer, and the second topside conductive layer is vertically aligned with the second backside conductive layer.

Example 11 is a die that includes the integrated circuit of any one of Examples 1-10.

Example 12 is an electronic device that includes a chip package having one or more dies. At least one of the one or more dies includes a first semiconductor device having a first semiconductor region extending from a first source or drain region in a first direction, and a first portion of a gate structure extending over the first semiconductor region in a second direction substantially orthogonal to the first direction, a second semiconductor device having a second semiconductor region extending from a second source or drain region in the first direction, and a second portion of the gate structure extending over the second semiconductor region in the second direction, a dielectric layer beneath the gate structure and beneath the first source or drain region and the second source or drain region, a dielectric fill adjacent to and between the first source or drain region and the second source or drain region along the second direction, a first conductive via extending through an entire height of the dielectric fill and the dielectric layer and adjacent to the first source or drain region along the second direction, a second conductive via extending through an entire height of the dielectric fill and the dielectric layer and adjacent to the second source or drain region along the second direction, a first backside conductive layer beneath the dielectric layer and contacting a bottom surface of the first conductive via, and a second backside conductive layer beneath the dielectric layer and contacting a bottom surface of the second conductive via.

Example 13 includes the electronic device of Example 12, wherein the dielectric layer has a thickness between 40 nm and 50 nm.

Example 14 includes the electronic device of Example 12 or 13, wherein the first source or drain region comprises silicon and phosphorous and the second source or drain region comprises silicon, germanium, and boron.

Example 15 includes the electronic device of any one of Examples 12-14, wherein the first semiconductor region comprises one or more first semiconductor nanoribbons and the second semiconductor region comprises one or more second semiconductor nanoribbons.

Example 16 includes the electronic device of Example 15, wherein the one or more first semiconductor nanoribbons and the one or more second semiconductor nanoribbons comprises germanium, silicon, or any combination thereof.

Example 17 includes the electronic device of any one of Examples 12-16, wherein the first conductive via extends along the first direction and is aligned along a first boundary of a standard unit cell that includes the first semiconductor region and the second semiconductor region, and the second conductive via extends along the first direction and is aligned along a second boundary of the standard unit cell, the second boundary being parallel to the first boundary.

Example 18 includes the electronic device of any one of Examples 12-17, wherein the at least one of the one or more dies further comprises: a first topside contact on a top surface of the first source or drain region; and a second topside contact on a top surface of the second source or drain region.

Example 19 includes the electronic device of Example 18, wherein the first topside contact extends along the second direction and also contacts the first conductive via, and the second topside contact extends along the second direction and also contacts the second conductive via.

Example 20 includes the electronic device of Example 19, wherein the at least one of the one or more dies further comprises a third conductive via extending between a top surface of the first topside contact and a first topside conductive layer, and a fourth conductive via extending between a top surface of the second topside contact and a second topside conductive layer.

Example 21 includes the electronic device of Example 20, wherein the first topside conductive layer is vertically aligned with the first backside conductive layer, and the second topside conductive layer is vertically aligned with the second backside conductive layer.

Example 22 includes the electronic device of any one of Examples 12-21, further comprising a printed circuit board, wherein the chip package is attached to the printed circuit board.

Example 23 is an integrated circuit that includes a standard unit cell having a first semiconductor device and a second semiconductor device. The first semiconductor device includes a first semiconductor region extending from a first source or drain region to a second source or drain region in a first direction, and a first portion of a gate structure extending over the first semiconductor region in a second direction substantially orthogonal to the first direction. The second semiconductor device includes a second semiconductor region extending from a third source or drain region to a fourth source or drain region in the first direction, and a second portion of the gate structure extending over the second semiconductor region in the second direction. The integrated circuit further includes a first conductive via extending along the first direction and aligned along a first boundary of the standard unit cell, and a second conductive via extending along the first direction and aligned along a second boundary of the standard unit cell. The first conductive via is adjacent to the first source or drain region along the second direction, and the second conductive via is adjacent to the second source or drain region along the second direction.

Example 24 includes the integrated circuit of Example 23, further comprising a dielectric layer beneath the gate structure, wherein the first conductive via and the second conductive via each extend through an entire thickness of the dielectric layer.

Example 25 includes the integrated circuit of Example 24, wherein the dielectric layer has a thickness between 40 nm and 50 nm.

Example 26 includes the integrated circuit of any one of Examples 23-25, wherein the first source or drain region and the second source or drain region comprise silicon and phosphorous, and the third source or drain region and the fourth source or drain region comprises silicon, germanium, and boron.

Example 27 includes the integrated circuit of any one of Examples 23-26, wherein the first semiconductor region comprises one or more first semiconductor nanoribbons and the second semiconductor region comprises one or more second semiconductor nanoribbons.

Example 28 includes the integrated circuit of Example 27, wherein the one or more first semiconductor nanoribbons and the one or more second semiconductor nanoribbons comprises germanium, silicon, or any combination thereof.

Example 29 includes the integrated circuit of any one of Examples 23-28, further comprising: a first backside conductive layer on a bottom surface of the first conductive via; a second backside conductive layer on a bottom surface of the second conductive via; a first topside contact on a top surface of the first source or drain region; and a second topside contact on a top surface of the third source or drain region.

Example 30 includes the integrated circuit of Example 29, wherein the first topside contact extends along the second direction and also contacts the first conductive via, and the second topside contact extends along the second direction and also contacts the second conductive via.

Example 31 includes the integrated circuit of Example 30, further comprising a third conductive via extending between a top surface of the first topside contact and a first topside conductive layer, and a fourth conductive via extending between a top surface of the second topside contact and a second topside conductive layer.

Example 32 includes the integrated circuit of Example 31, wherein the first topside conductive layer is vertically aligned with the first backside conductive layer, and the second topside conductive layer is vertically aligned with the second backside conductive layer.

Example 33 is a die that includes the integrated circuit of any one of Examples 23-32

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor region extending from a first source or drain region in a first direction;
a second semiconductor region extending from a second source or drain region in the first direction;
a gate structure extending over the first semiconductor region and the second semiconductor region in a second direction substantially orthogonal to the first direction;
a dielectric layer beneath the gate structure and beneath the first source or drain region and the second source or drain region;
a dielectric fill adjacent to and between the first source or drain region and the second source or drain region along the second direction;
a first conductive via extending through an entire height of the dielectric fill and the dielectric layer, and adjacent to the first source or drain region along the second direction;
a second conductive via extending through an entire height of the dielectric fill and the dielectric layer, and adjacent to the second source or drain region along the second direction;
a first backside conductive layer beneath the dielectric layer and contacting a bottom surface of the first conductive via; and
a second backside conductive layer beneath the dielectric layer and contacting a bottom surface of the second conductive via.

2. The integrated circuit of claim 1, wherein the dielectric layer has a thickness between 40 nm and 50 nm.

3. The integrated circuit of claim 1 or 2, wherein the first source or drain region comprises silicon and phosphorous and the second source or drain region comprises silicon, germanium, and boron.

4. The integrated circuit of any one of claims 1-3, wherein the first semiconductor region comprises one or more first semiconductor nanoribbons and the second semiconductor region comprises one or more second semiconductor nanoribbons.

5. The integrated circuit of claim 4, wherein the one or more first semiconductor nanoribbons and the one or more second semiconductor nanoribbons comprises germanium, silicon, or any combination thereof.

6. The integrated circuit of any one of claims 1-5, wherein the first conductive via extends along the first direction and is aligned along a first boundary of a standard unit cell that includes the first semiconductor region and the second semiconductor region, and the second conductive via extends along the first direction and is aligned along a second boundary of the standard unit cell, the second boundary being parallel to the first boundary.

7. The integrated circuit of any one of claims 1-6, further comprising:
a first topside contact on a top surface of the first source or drain region; and
a second topside contact on a top surface of the second source or drain region.

8. The integrated circuit of claim 7, wherein the first topside contact extends along the second direction and also contacts the first conductive via, and the second topside contact extends along the second direction and also contacts the second conductive via.

9. The integrated circuit of claim 8, further comprising a third conductive via extending between a top surface of the first topside contact and a first topside conductive layer, and a fourth conductive via extending between a top surface of the second topside contact and a second topside conductive layer.

10. The integrated circuit of claim 9, wherein the first topside conductive layer is vertically aligned with the first backside conductive layer, and the second topside conductive layer is vertically aligned with the second backside conductive layer.

11. A die that includes the integrated circuit of any one of claims 1-10.

12. An integrated circuit comprising:
a standard unit cell having a first semiconductor device and a second semiconductor device, the standard unit cell having a layout that is repeated across at least a portion of the integrated circuit;
wherein the first semiconductor device comprises a first semiconductor region extending from a first source or drain region to a second source or drain region in a first direction, and a first portion of a gate structure extending over the first semiconductor region in a second direction substantially orthogonal to the first direction;
wherein the second semiconductor device comprises a second semiconductor region extending from a third source or drain region to a fourth source or drain region in the first direction, and a second portion of the gate structure extending over the second semiconductor region in the second direction;
a first conductive via extending along the first direction and aligned along a first boundary of the standard unit cell, the first conductive via being adjacent to the first source or drain region along the second direction; and
a second conductive via extending along the first direction and aligned along a second boundary of the standard unit cell, the second conductive via being adjacent to the second source or drain region along the second direction.

13. The integrated circuit of claim 12, further comprising a dielectric layer beneath the gate structure, wherein the first conductive via and the second conductive via each extend through an entire thickness of the dielectric layer.

14. The integrated circuit of claim 12 or 13, wherein the first source or drain region and the second source or drain region comprise silicon and phosphorous, and the third source or drain region and the fourth source or drain region comprises silicon, germanium, and boron.

15. The integrated circuit of any one of claims 12-14, further comprising:
a first backside conductive layer on a bottom surface of the first conductive via;
a second backside conductive layer on a bottom surface of the second conductive via;
a first topside contact on a top surface of the first source or drain region; and
a second topside contact on a top surface of the third source or drain region;
wherein the first topside contact extends along the second direction and also contacts the first conductive via, and the second topside contact extends along the second direction and also contacts the second conductive via.
